# EUROPEAN PATENT APPLICATION

(11) **EP 4 803 656 A1**
(43) Date of publication of application: **09.09.2026**
(21) Application number: 25882951.4
(22) Date of filing: 30.07.2025
(51) Int. Cl.: C23C 28/00, C25D 3/04, C23C 14/06, B24C 1/08, B30B 3/00, H01M 4/04, B21B 27/00

(54) **ROLLING ROLL, METHOD FOR MANUFACTURING ROLLING ROLL, AND METHOD FOR MANUFACTURING ELECTRODE USING SAME**

(30) Priority: 23.10.2024 KR 20240145925; 25.03.2025 KR 20250038136
(71) Applicant: LG Energy Solution, Ltd., Seoul 07335 (KR)
(72) Inventor: MOON, Kihyeon, Daejeon 34122 (KR); HONG, Soohyung, Daejeon 34122 (KR); PARK, Jinhui, Daejeon 34122 (KR); NA, Inseong, Daejeon 34122 (KR); CHO, Hyeondong, Daejeon 34122 (KR)
(74) Representative: Plasseraud IP
(86) International application number: PCT/KR2025/011321
(87) International publication number: WO 2026/089220

(57) **Abstract**

A rolling roll according to one embodiment of the present disclosure comprises: a roll base material; and a chromium-containing plating layer formed on the roll base material, with the maximum length of the cracks formed on the surface being 5 µm or less.

A rolling roll according to another embodiment comprises a roll base material; a chromium-containing plating layer formed on the roll base material, and a first coating layer formed on the chromium-containing plating layer and comprising titanium nitride.

A method for manufacturing a rolling roll according to another embodiment comprises the steps of: forming a surface irregularity portion on the surface of a roll base material; forming a chromium-containing plating layer on the roll base material using a plating solution containing a chromium-containing raw material and sulfuric acid; and coating a metal nitride layer on the chromium-containing plating layer, wherein in the forming the chromium-containing plating layer, the plating solution further comprises a sulfonic acid-based organic catalyst, or plating is performed in a state where the plating solution is heated to a temperature of 65°C or more to 90°C or less.

A method for manufacturing an electrode according to a further embodiment comprises the steps of: forming an electrode active material layer on a current collector; and rolling the electrode active material layer using the rolling roll.

## Description

### [TECHNICAL FIELD]

### Cross Citation with Related Application(s)

This application claims priority to and the benefit of Korean Patent Application No. 10-2024-0145925, filed on October 23, 2024, and Korean Patent Application No. 10-2025-0038136, filed on March 25, 2025, the disclosures of which are incorporated herein by reference in their entirety.

The present disclosure relate to a rolling roll, a method for manufacturing a rolling roll, and a method for manufacturing an electrode using the same, and more particularly, to a rolling roll comprising: a roll base material; and a chromium-containing plating layer formed on the roll base material, with the maximum length of the cracks formed on the surface being 5 µm or less, and a method for manufacturing a rolling roll and a method for manufacturing an electrode using the same.

### [BACKGROUND]

The manufacturing process for secondary battery electrodes is carried out through mixing, coating, rolling, slitting and notching, and drying processes. In particular, in the rolling process, the coated active material electrode is rolled to reduce its thickness and improve its density. However, in the rolling process, the active material electrode passes between a pair of upper and lower rolling rolls, and the upper and lower rolling rolls are pressed down to reduce the thickness of the active material electrode, which may cause friction between the rolling roll surfaces and the active material electrode. For this reason, the rolling process has the problem that the rolling roll surface wears out and the service life of the rolling rolls becomes shortened.

To prevent such problems, a hard chrome plating layer is typically formed onto the rolling roll surface, and the hardness of the rolling roll is increased to about 700-900 Hv, thereby reducing the degree of wear of the rolling roll and enhancing its service life. However, hard chromium plating uses a mixture of chromic anhydride and sulfuric acid (CrO₃ and H₂SO₄) as a plating bath, wherein hydrogen generated from the plating bath may remain and penetrate into the base metal, leading to hydrogen embrittlement, and residual stress during plating may cause hair cracks in the plating layer. Hair cracks are large enough to allow the plating solution to penetrate between the cracks. Thus, there is a problem that during the roll heat treatment for hydrogen removal, the plating solution can flow out and remain on the roll surface, and defects are induced during the application of additional high-hardness coating. Moreover, it is also impossible to exclude the possibility that polishing and cleaning solutions may penetrate between cracks during the roll surface polishing and cleaning processes, which are preparatory steps for high-hardness coatings, thereby causing roll surface defects. Furthermore, if hair cracks on the plating surface propagate due to stress from rolling loads, the cracks may connect with each other and fall off, which is a critical factor in shortening the service life of rolls.

To further enhance the service life of rolls, a DLC (Diamond Like Carbon) deposition or WC (tungsten carbide) coating may be added onto the hard chrome plating layer to increase the hardness of the rolling roll to around 2,000 Hv, thereby performing the rolling.

DLC is deposited using a hydrocarbon-based (CₙHₙ) plasma gas. While the hardness can be increased to a level of 2,000 Hv, the coefficient of friction is excessively low at around 0.05, which may cause slip phenomenon during rolling. Furthermore, since the hydrogen plasma generates large quantities of hydrogen ions and atoms, there is a possibility that the generated hydrogen may diffuse into the base material, leading to hydrogen embrittlement of the base material.

WC primarily employs a thermal spray coating method, but the thermal spray coating method has the problem that due to the relatively large particle size of WC, the surface becomes rough, leading to quality defects in the rolling electrode. As multilayer laminated sections of WC and WC/C layers are formed through sputtering of acetylene gas (C₂H₂) and tungsten carbide (WC), the service life of coating layers can be improved, but the use of hydrocarbon-based plasma gases generates large quantities of hydrogen ions and atoms, and when the generated hydrogen diffuses into the base material, it may cause hydrogen embrittlement, and hydrogen molecule formation can also cause blister defects.

Therefore, there is a need to develop a rolling roll, a method for manufacturing a rolling roll, and a method for manufacturing an electrode using the same, in which foreign matter defects and hydrogen defects in a final coating film can be minimized by preventing penetration of a plating solution, but also the hardness of the final coating film may be relatively increased to wear resistance.

### [DETAILED DESCRIPTION OF THE INVENTION[]

### [Technical Problem]

It is an object of the present disclosure to provide a rolling roll comprising a chromium-containing plating layer having a maximum crack length of 5 µm or less formed on the surface of the roll base material, a method for manufacturing a rolling roll, and a method for manufacturing an electrode using the same.

The objects of the present disclosure are not limited to the objects mentioned above, and additional other objects not described herein should be clearly understood by those skilled in the art from the following detailed description and the accompanying drawings.

### [Technical Solution]

According to an aspect of the present disclosure, there is provided a rolling roll comprising: a roll base material; and a chromium-containing plating layer formed on the roll base material, with the maximum length of the cracks formed on the surface being 5 µm or less.

The roll base material may have a surface irregularity portion with a maximum height of 5 µm or more to 25 µm or less.

The roll base material may comprise chromium steel.

A thickness of the chromium-containing plating layer may be 100 µm or more to 150 µm or less, and a hardness of the chromium-containing plating layer may be 1000Hv or more to 1300Hv or less.

A residual hydrogen density of the chromium-containing plating layer may be 0.1 ppm/cm³ or more to 0.25 ppm/cm³ or less.

The rolling roll according to the present embodiment further comprises a coating layer formed on the chromium-containing plating layer, wherein the coating layer may comprise a metal nitride.

The coating layer may comprise a chromium nitride layer formed on the chromium-containing plating layer, and a titanium nitride layer formed on the chromium nitride layer.

The coating layer may further comprise a chromium coating layer located between the chromium-containing plating layer and the chromium nitride layer.

According to another aspect of the present disclosure, there is provided a rolling roll comprising: a roll base material; a chromium-containing plating layer formed on the roll base material, and a first coating layer formed on the chromium-containing plating layer and comprising titanium nitride.

The rolling roll according to the present embodiment may further comprise one or more second coating layers formed between the chromium-containing plating layer and the first coating layer, and comprising chromium or its nitride.

A thickness of the second coating layer may be 0.2 µm or more to 1 µm or less, and a hardness of the second coating layer may be 1000Hv or more to 2000Hv or less.

The first coating layer may comprise: a first sub-coating layer formed on the chromium-containing plating layer or the second coating layer, and comprising titanium nitride (TiN); a second sub-coating layer formed on the first sub-coating layer, and comprising a titanium-aluminum composite nitride; and a third sub-coating layer formed on the second sub-coating layer, and comprising titanium carbonitride (TiCN).

The first to third sub-coating layers each have a thickness of 0.3 µm or more to 1.5 µm or less, and the hardness may increase as it goes from the first sub-coating layer to the third sub-coating layer.

The first sub-coating layer may have a hardness of 2000 Hv or more, the second sub-coating layer may have a hardness of 2500 Hv or more, and the third sub-coating layer may have a hardness of 3000 Hv or more.

The rolling roll may have a coefficient of friction that decreases from the first sub-coating layer to the third sub-coating layer.

The first sub-coating layer may have a coefficient of friction of 0.65 to 0.75, the second sub-coating layer may have a coefficient of friction of 0.55 to 0.65, and the third sub-coating layer may have a coefficient of friction of 0.35 to 0.45.

The first to third sub-coating layers may have a residual hydrogen density of 100 ppm/cm³ or less.

According to yet another aspect of the present disclosure, there is provided a method for manufacturing a rolling roll, the method comprising the steps of: forming a surface irregularity portion on the surface of a roll base material; forming a chromium-containing plating layer on the roll base material using a plating solution containing a chromium-containing raw material and sulfuric acid; and coating a metal nitride layer on the chromium-containing plating layer, wherein in the forming the chromium-containing plating layer, the plating solution further comprises a sulfonic acid-based organic catalyst, or plating is performed in a state where the plating solution is heated to a temperature of 65°C or more to 90°C or less.

The step of forming a surface irregularity portion may comprise a step of sandblasting or shotblasting the surface of the roll base material.

The method for manufacturing a rolling roll according to the present embodiment may further comprise a step of removing residual hydrogen by heat treatment at a temperature of 130°C or more to 250°C or less for 8 hours or more and 40 hours or less, after forming the chromium-containing plating layer.

The method for manufacturing a rolling roll according to the present embodiment may further comprise a step of polishing and cleaning the chromium-containing plating layer between the step of forming the chromium-containing plating layer and the step of coating the metal nitride layer.

The chromium-containing raw material may comprise chromic anhydride, and the sulfonic acid-based organic catalyst may comprise an alkyl sulfonate having 1 to 5 carbon atoms.

The step of coating a metal nitride layer may comprise a step of performing plasma vacuum deposition (sputtering) of the metal nitride.

The step of coating a metal nitride layer may comprise: a step of depositing titanium nitride (TiN) on the chromium-containing plating layer; a step of depositing a titanium-aluminum composite nitride on the titanium nitride; and a step of depositing titanium carbonitride (TiCN) on the titanium-aluminum composite nitride.

The method for manufacturing a rolling roll according to the present embodiment may further comprise a step of coating chromium or chromium nitride on the chromium-containing plating layer between the step of forming the chromium-containing plating layer and the step of coating the metal nitride layer.

According to yet a further aspect of the present disclosure, there is provided a method for manufacturing an electrode, the method comprising the steps of: forming an electrode active material layer on a current collector; and rolling the electrode active material layer using the above-mentioned rolling roll.

### [Advantageous Effects]

A rolling roll, a method for manufacturing a rolling roll, and a method for manufacturing an electrode using the same according to embodiments of the present disclosure have advantages that the rolling roll includes a chromium-containing plating layer in which the maximum length of cracks formed on the surface of the roll base material is 5 µm or less, whereby foreign material defects and hydrogen defects in the final coating film may be minimized by preventing penetration of the plating solution, and the hardness of the final coating film may be relatively increased to improve wear resistance.

Also, in a rolling roll, a method for manufacturing a rolling roll, and a method for manufacturing an electrode using the same according to embodiments of the present disclosure, crack refinement or crack-free plating is performed on the base material of the rolling roll, thereby forming a plating layer that prevents the plating solution from penetrating between the cracks and also preventing the surface of the plating layer from falling off due to the rolling load, and enhancing the service life of the coating layer of the mill roll.

In addition, in a rolling roll, a method for manufacturing a rolling roll, and a method for manufacturing an electrode using the same according to embodiments of the present disclosure, Ti-based nitride may be deposited on the plating layer to form a coating layer for improving hardness, whereby the hardness is higher than existing DLC, and a coefficient of friction may also be ensured at a level suitable for rolling.

The effects of the present disclosure are not limited to the effects mentioned above and additional other effects not described above will be clearly understood from the detailed description and the appended claims by those skilled in the art.

### [BRIEF DESCRIPTION OF THE DRAWINGS]

FIG. 1 is a diagram showing a rolling roll according to one embodiment of the present disclosure.
FIGS. 2 and 3 are enlarged views of the surface of the central portion of the rolling roll of FIG. 1.
FIG. 4 is an enlarged view of the surface of the central portion of the rolling roll of Comparative Example.
FIGS. 5 to 9 are flowcharts showing a method for manufacturing a rolling roll according to another embodiment of the present disclosure.
FIG. 10 is a flowchart showing a method for manufacturing an electrode according to another embodiment of the present disclosure.
FIGS. 11 and 12 are SEM images showing the experimental results of Experimental Example 1.

### [DETAILED DESCRIPTION OF THE EMBODIMENTS]

Hereinafter, various embodiments of the present disclosure will be described in detail with reference to the accompanying drawings so that those skilled in the art can easily implement them. The present disclosure may be modified in various different ways, and is not limited to the embodiments set forth herein.

Portions that are irrelevant to the description will be omitted to clearly describe the present disclosure, and like reference numerals designate like elements throughout the specification.

Further, in the figures, the size and thickness of each element are arbitrarily illustrated for convenience of description, and the present disclosure is not necessarily limited to those illustrated in the figures. In the figures, the thickness of layers, regions, etc. are exaggerated for clarity. In the figures, for convenience of description, the thicknesses of some layers and regions are exaggerated.

Further, throughout the specification, when a portion is referred to as "including" a certain component, it means that the portion can further include other components, without excluding the other components, unless otherwise stated.

Further, throughout the specification, when referred to as "planar", it means when a target portion is viewed from the upper side, and when referred to as "cross-sectional", it means when a target portion is viewed from the side of a cross section cut vertically.

Below, a rolling roll of the present disclosure, a method for manufacturing a rolling roll, and a method for manufacturing an electrode using the same according to the present embodiment will be described in detail.

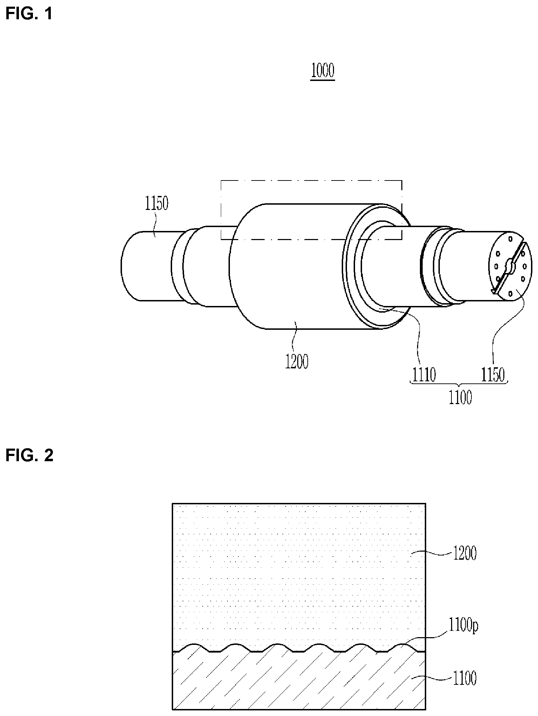

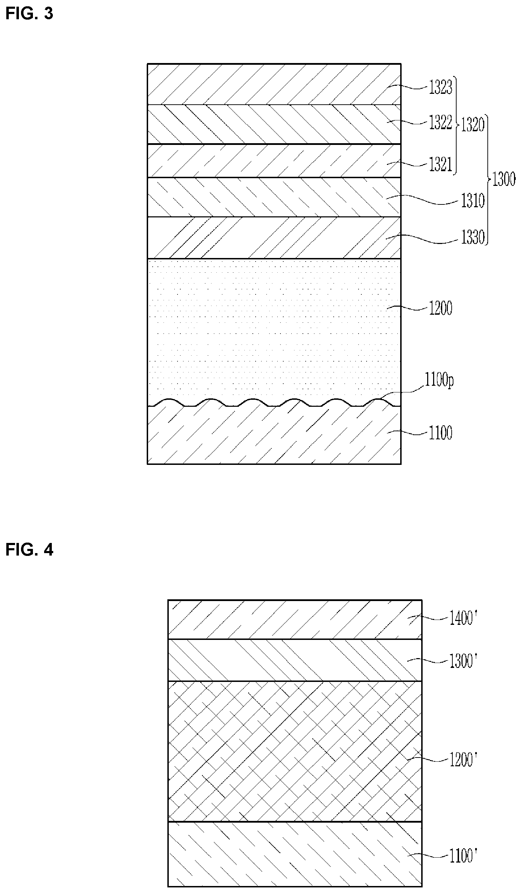

FIG. 1 is a diagram showing a rolling roll according to one embodiment of the present disclosure. FIGS. 2 and 3 are enlarged views of the surface of the central portion of the rolling roll of FIG. 1.

Referring to FIGS. 1 and 2, a rolling roll 1000 according to one embodiment of the present disclosure includes a roll base material 1100; and a chromium-containing plating layer 1200 formed on the roll base material 1100. Here, the rolling roll 1000 may be a main roll used in the rolling process of a method for manufacturing an electrode for a lithium secondary battery.

More specifically, the roll base material 1100 may include a central portion 1110 that is a portion that presses down the electrode, and a pair of end portions 1150 that are integrated with the central portion 1110. However, the shape of the roll base material 1100 is not limited to that shown in FIG. 1, and various shapes may be applied as long as they are shapes that can press down the electrode.

The roll base material 1100 may include chromium steel. More specifically, the roll base material 1100 may be made of high-chromium steel. As an example, the roll base material 1100 may be made of 3% chromium steel. Furthermore, the hardness of the roll base material 1100 may be 700 Hv or more to 800 Hv or less.

Here, the hardness may be the average value of values measured using a Vickers hardness tester. For example, the hardness may be a value determined as the average of five measurements under a load of 300 kgf. The hardness may also be described similarly in the following context.

The roll base material 1100 may have a modified surface. More specifically, the surface of the roll base material 1100 may be formed with a surface irregularity portion 1100p after removing foreign matters by a method such as sandblasting or shot blasting. As an example, as shown in FIG. 2, the roll base material 1100 may have a surface irregularity portion 1100p having a maximum height of 5 µm or more and 25 µm or less. Here, the surface irregularity portion 1100p may be formed on the surface of the roll base material 1100 facing the chromium-containing plating layer 1200.

Thereby, in the rolling roll 1000 according to the present embodiment, the surface irregularity portion 1100p formed on the roll base material 1100 has a maximum height within the above-mentioned range, which expands the contact area between the roll base material 1100 and the chromium-containing plating layer 1200, effectively enhancing the adhesive strength and effectively preventing the chromium-containing plating layer 1200 from falling off from the roll base material 1100.

Unlike the same, if the surface irregularity portion 1100p are less than 5 µm, in addition to the intrinsic adhesive strength between the roll base material 1100 and the chromium-containing plated layer 1200, it may be difficult to effectively further enhance the adhesive strength. Further, if the surface irregularity portion 1100p exceed 25 µm, it is difficult to secure a sufficient thickness for the chromium-containing plating layer 1200, and the thickness deviation of the chromium-containing plating layer 1200 becomes larger depending on the location of the surface irregularity portion 1100p, which may cause a problem of deterioration of adhesive strength and occurrence of surface cracks.

The maximum length of cracks formed on the surface of the chromium-containing plating layer 1200 may be 5 µm or less. As an example, the crack length can be measured by capturing an SEM image of the chromium-containing plating layer 1200 through an electron microscope, magnifying the image at 1500x (unit: µm), and calculating the average of the ten maximum values observed. The following contents can also be explained in a similar manner.

More specifically, the chromium-containing plating layer 1200 may be a plating layer that has been crack-refined or made crack-free when plating with a chromium-containing plating solution containing a chromium-containing raw material (chromium oxide) and sulfuric acid. As an example, the crack-refined or crack-free chromium-containing plating layer 1200 may be formed by adding a sulfonic acid-based organic catalyst (e.g., alkyl sulfonate) to the chromium-containing plating solution, or by plating the chromium-containing plating solution at a temperature of 65°C or more to 90°C or less (more preferably, 70°C or more to 80°C or less). Such crack-refined or crack-free plating may make the crack length to 5 µm.

Thereby, in the rolling roll 1000 according to the present embodiment, as the maximum length of the cracks formed on the surface of the chromium-containing plating layer 1200 is formed to be 5 µm or less, the maximum length of cracks formed on the surface of the chromium-containing plating layer 1200 is extremely short compared to conventional plating where the maximum crack length is 12-15 µm. That is, as a result, the rolling roll 1000 according to the present embodiment can prevent connection between cracks and minimize occurrence of defects due to cracks. That is, this can dramatically reduce wear on the rolling roll 1000, thereby decreasing production costs and lowering the electrode defect rate.

Unlike the same, since the maximum length of cracks in general plating performed with conventional rolling rolls is 12-15 µm,long cracks occurring in conventional plating can be connect to each other three-dimensionally, which causes a problem that parts of the plating layer surface are desorbed due to the rolling roll load, and subsequent further coating layers are also peeled off.

Additionally, the thickness of the chromium-containing plating layer 1200 may be 100 µm or more to 150 µm or less, and the hardness of the chromium-containing plating layer 1200 may be 1000 Hv or more to 1300 Hv or less.

As a result, in the rolling roll 1000 according to the present embodiment, the hardness gradually increases in the order of the base material 1100 and the chromium-containing plating layer 1200, effectively preventing a decrease in adhesion due to a sudden change in hardness. In addition, the base material 1100 and the chromium-containing plating layer 1200 contain the same components, which provides continuity of the components and effectively prevents a decrease in adhesion due to a sudden change in the components.

Further, the residual hydrogen density after heat treatment of the chromium-containing plating layer 1200 may be 0.1 ppm/cm³ or more to 0.25 ppm/cm³ or less. Here, the residual hydrogen density can be measured using TDS (Thermal Desorption Spectroscopy) separately before and after heat treatment. As an example, the residual hydrogen density was measured using Thermal Desorption-Gas Chromatography Mass Spectrometry (TD-GC/MS), and may be a value obtained by dividing the measured values of the amount of the amount of hydrogen gas desorbed from the sample surface by heating the respective samples before and after heat treatment to 80°C, by the volume of the sample.

More specifically, the chromium-containing plating layer 1200 may be formed on the surface of the roll base material 1100 through crack refinement or crack-free plating, and then heat-treated at a temperature of 130°C or more to 250°C or less for the period of 8 to 40 hours. After the heat treatment, the residual hydrogen contained in the chromium-containing plating layer 1200 is removed, and the residual hydrogen density contained in the chromium-containing plating layer 1200 may be within the above-mentioned range,

Thereby, in the rolling roll 1000 according to the present embodiment, the chromium-containing plating layer 1200 has the above-mentioned residual hydrogen density after heat treatment, which prevents the residual hydrogen from penetrating into the roll base material 1100 and causing hydrogen embrittlement, and can also prevent hydrogen molecules from forming and causing blister defects in the coating layer 1300 (FIG. 3).

As shown in FIG. 3, the rolling roll 1000 according to the present embodiment may further include a coating layer 1300 formed on a chromium-containing plating layer 1200. Here, the coating layer 1300 may include a metal nitride. As an example, the coating layer 1300 may include a chromium nitride layer 1310 formed on the chromium-containing plating layer 1200 and a titanium nitride layer 1320 formed on the chromium nitride layer 1310. Furthermore, the coating layer 1300 may further include a chromium coating layer 1330 located between the chromium-containing plating layer 1200 and the chromium nitride layer 1310.

The coating layer 1300 will be described in more detail below, and the present embodiment can be described in a similar manner.

Referring to FIGS. 1 and 3, a rolling roll 1000 according to another embodiment of the present disclosure comprises: a roll base material 1100; a chromium-containing plating layer 1200 formed on the roll base material 1100, and a first coating layer 1320 formed on the chromium-containing plating layer 1200 and comprising titanium nitride.

Here, the chromium-containing plating layer 1200 may be a crack-refined or crack-free plating layer, as described above with reference to FIG. 2, or may be a plating layer according to conventional crack plating.

In addition, the rolling roll 1000 according to the present embodiment may further include one or more second coating layers 1310, 1330 formed between the chromium-containing plating layer 1200 and the first coating layer 1320, and comprising chromium or its nitride. More specifically, the second coating layers 1310, 1330 may refer to a chromium coating layer 1330 and a chromium nitride layer 1310.

Here, the first coating layer 1320 and the second coating layers 1310, 1330 may be deposited by a plasma method.

As an example, as shown in FIG. 3, the rolling roll 1000 according to the present embodiment have a structure in which a chromium coating layer 1330 may be located between a chromium-containing plating layer 1200 and a chromium nitride layer 1310, and a chromium nitride layer 1310 may be located between the chromium coating layer 1330 and the first coating layer 1320.

The first coating layer 1320 may comprise: a first sub-coating layer 1321 formed on the chromium-containing plating layer 1310 or the second coating layers 1310, 1330, and comprising titanium nitride (TiN); a second sub-coating layer 1322 formed on the first sub-coating layer 1321, and comprising a titanium-aluminum composite nitride; and a third sub-coating layer 1323 formed on the second sub-coating layer 1322, and comprising titanium carbonitride (TiCN).

More specifically, the first to third sub-coating layers 1321, 1322, 1323 each have a thickness of 0.3 µm or more to 1.5 µm or less, and the hardness may increase as it goes from the first sub-coating layer 1321 to the third sub-coating layer 1323. As an example, the first sub-coating layer 1321 may have a hardness of 2000 Hv or more, the second sub-coating layer 1322 may have a hardness of 2500 Hv or more, and the third sub-coating layer 1323 may have a hardness of 3000 Hv or more.

Thereby, in the rolling roll 1000 according to the present embodiment, the first coating layer 1320 can have a gradually increasing hardness, which can effectively prevent a decrease in adhesion due to abrupt changes in hardness, and provide the advantage of effectively improving wear resistance as the final coating film has a hardness of 3000 Hv or more. In addition, even after the Ti nitride coating on the outermost surface is peeled off, the hardness change is small, which can prevent the rolling roll 1000 from being rapidly worn.

Additionally, the thickness of the second coating layers 1310, 1330 may be 0.2 µm or more to 1 µm or less, and the hardness of the second coating layers 1310, 1330 may be 1000 Hv or more to 2000 Hv or less.

Thereby, in the rolling roll 1000 according to the present embodiment, the hardness gradually increases in the order of the chromium-containing plating layer 1200, the second coating layers 1310, 1330, and the first coating layer 1320, which can effectively prevent a decrease in adhesion due to abrupt changes in hardness.

In addition, the second coating layers 1310, 1330 contain the same components as the chromium-containing plating layer 1200, which can provide continuity in the components and effectively prevent a decrease in adhesion due to abrupt changes in the components. Similarly, since the first coating layer 1320 is entirely composed of titanium nitride, it can also provide continuity in composition, and thus effectively prevent a decrease in adhesion due to abrupt changes in composition.

The coefficient of friction may decrease as it goes from the first sub-coating layer 1321 to the third sub-coating layer 1323. Here, the coefficient of friction may be an average value measured using a tribometer. As an example, the coefficient of friction may be an average value measured using a tribometer under conditions of a load of 5 N and a speed of 200 rpm. The coefficient of friction may be similarly described even in the following contents.

As an example, the first sub-coating layer 1321 may have a coefficient of friction of 0.65 to 0.75, the second sub-coating layer 1322 may have a coefficient of friction of 0.55 to 0.65, and the third sub-coating layer 1323 may have a coefficient of friction of 0.35 to 0.45.

Thereby, in the rolling roll 1000 according to the present embodiment, as the coefficient of friction of the first coating layer 1320 is 0.3 or more, the coefficient of friction of the final coating film is ensured at a level suitable for rolling while ensuring sufficient adhesion between the coating layers 1300, thereby effectively preventing the phenomenon in which the electrode slips between the rolling rolls 1000.

The first to third sub-coating layers 1321, 1322, 1323 may have a residual hydrogen density of 100 ppm/cm³ or less.

Thereby, in the rolling roll 1000 according to the present embodiment, the first to third sub-coating layers 1321, 1322, 1323 have the above-mentioned residual hydrogen density, which can prevent the residual hydrogen from penetrating into the roll base material 1100 and causing hydrogen embrittlement, and also can prevent hydrogen molecules from forming and causing blister defects in the coating layer 1300.

FIG. 4 is an enlarged view of the surface of the central portion of the rolling roll of Comparative Example.

Referring to FIG. 4, a rolling roll according to Comparative Example includes a roll base material 1100'; a general hard chrome plating layer 1200' formed on the roll base material 1100'; a chromium nitride layer 1300' formed on the general hard chrome plating layer 1200'; and a DLC (Diamond Like Coating) coating layer 1400'.

Here, the roll base material 1100' may be made of high-chromium steel having a hardness of 700 Hv or more to 800 Hv or less. Further, the general hard chrome plating layer 1200' may have a thickness of 100 µm or more to 150 µm or less and a hardness of 800 Hv or more to 1000 Hv or less. Further, the chromium nitride layer 1300' may have a thickness of 0.1 µm or more to 1.0 µm or less and a hardness of 1500 Hv or more to 1900 Hv or less. Further, the DLC coating layer 1400' may have a thickness of 1 µm or more to 2 µm or less, a hardness of 2000 Hv, and a coefficient of friction of 0.05 or more to 0.2 or less.

In this case, the general hard chrome plating layer 1200' has a problem in that, since the maximum length of the cracks is 12 ~ 15 µm as described above, such long cracks can be connected to each other three-dimensionally, which causes a problem that parts of the plating layer surface are desorbed due to the rolling roll load, and subsequent further coating layers are also peeled off.

Further, since the DLC coating layer 1400' is generally formed by an ion beam deposition method using a carbon-hydrogen plasma gas, the generated hydrogen atoms aggregate while forming hydrogen molecules, and form bubbles, which may lead to blister-type defects. These defects may, in turn, cause peeling of the coating layer. Additionally, as described above, the hardness of the DLC coating layer 1400' is limited to 2,000 Hv, which may not be sufficient to ensure wear resistance of the rolling roll. Additionally, since the DLC coating layer 1400' has an excessively low coefficient of friction (0.05-0.2), and the adhesion to the roll base material 1100' is insufficient, a buffer layer such as the chromium nitride layer 1300' must be necessarily provided between the DLC coating layer 1400' and the roll base material 1100'.

Unlike the same, as shown in FIGS. 1 to 3, in the rolling roll 1000 according to the present embodiment, as the cracks formed on the surface of the chromium-containing plating layer 1200 is formed with a maximum length of 5 µm or less, it is possible to minimize the induction of defects due to the cracks and significantly reduce wear of the rolling roll 1000, thereby reducing the production costs and the electrode defect rate.

In addition, the rolling roll 1000 according to the present embodiment deposits a first coating layer 1320 containing titanium-based nitride (TiN, TiCN, TiAlCN) having a low residual hydrogen density, high hardness, and a relatively high coefficient of friction using a plasma method, which reduces friction with the electrode containing the active material that causes wear, effectively extending the service life of the rolling roll.

Next, a method for manufacturing a rolling roll according to another embodiment of the present disclosure will be described.

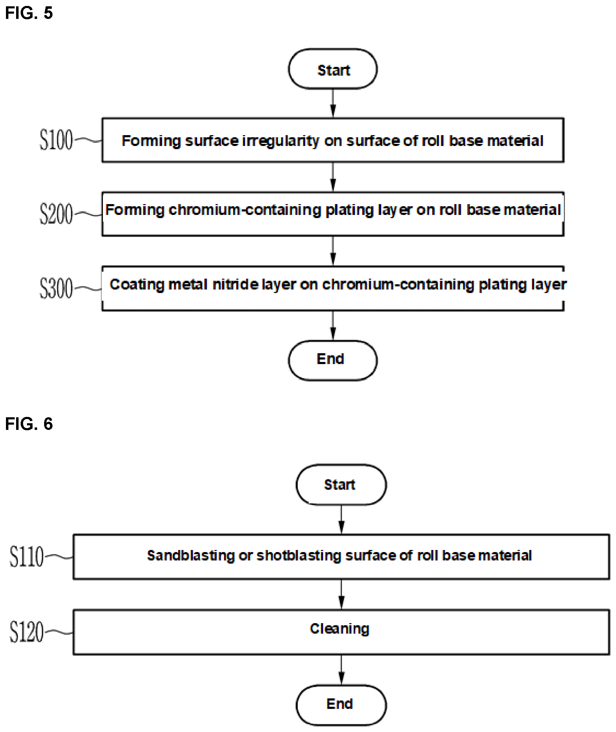

FIGS. 5 to 9 are flowcharts showing a method for manufacturing a rolling roll according to another embodiment of the present disclosure.

Referring to FIGS. 3 and 5, a method for manufacturing a rolling roll according to another embodiment of the present disclosure comprises: a step (S100) of forming a surface irregularity portion 1100p on the surface of a roll base material 1100; a step (S200) of forming a chromium-containing plating layer 1200 on the roll base material 1100 using a plating solution containing a chromium-containing raw material and sulfuric acid; and a step (S300) of coating a metal nitride layer 1320 on the chromium-containing plating layer 1200.

Referring to FIGS. 3 and 6, the step (S100) of forming a surface irregularity portion may comprise a step (S110) of sandblasting or shotblasting the surface of the roll base material 1100. Additionally, after step (S110), a step (S120) of cleaning the surface of the roll base material 1100 may be further performed.

In the step (S200) of forming the chromium-containing plating layer, the chromium-containing raw material may include anhydrous chromic acid.

In the step (S200) of forming the chromium-containing plating layer, crack refinement or crack-free plating may be performed by adding a sulfonic acid-based organic catalyst to the chromium-containing plating solution, or by heating the chromium-containing plating solution to a temperature of 65°C or more to 90°C or less (more preferably, a temperature of 70°C or more to 80°C or less). In this case, the sulfonic acid-based organic catalyst may include an alkyl sulfonate having 1 to 5 carbon atoms.

Referring to FIGS. 3, 5, and 7, the method for manufacturing a rolling roll according to the present embodiment may further comprise a step (S400) of removing residual hydrogen by heat treatment at a temperature of 130°C or more to 250°C or less for the period of 8 hours or more to 40 hours or less after strep (S200) of forming a chromium-containing plating layer. More specifically, step (S400) may be performed between steps (S200) and (S300). In this case, the heating temperature for hydrogen removal is 140°C or more to 200°C or less, and the holding time is 10 hours or more to 30 hours or less. Then, cooling is performed by furnace cooling, and cooling is performed until the temperature becomes 50°C or less.

In addition, the method may further comprise steps (S500, S600) of polishing and cleaning the chromium-containing plating layer 1200 between the step (S200) of forming the chromium-containing plating layer and the step (S300) of coating the metal nitride layer. More specifically, steps (S500, S600) may adjust the coefficient of friction so as to not exceed 0.7 by securing roughness through surface polishing after the step (S400) of removing residual hydrogen by heat treatment. Additionally, in step (S600) after step (S500), the surface of the rolling roll 1000 can be cleaned by ultrasonic or plasma cleaning, and then finally, the step (S300) of coating the metal nitride layer can be performed.

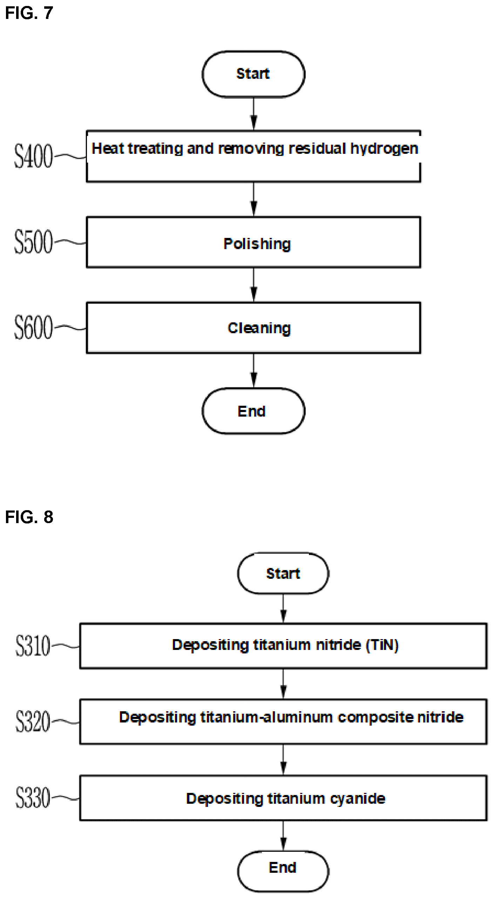

The step (S300) of coating the metal nitride layer may comprise a step of performing plasma vacuum deposition (sputtering) of the metal nitride. More specifically, referring to FIGS. 3 and 8, the step (S300) of coating the metal nitride layer may comprise: a step (S310) of depositing titanium nitride (TiN) on the chromium-containing plating layer 1200; a step (S320) of depositing a titanium-aluminum composite nitride on the titanium nitride; and a step (S330) of depositing titanium carbonitride (TiCN) on the titanium-aluminum composite nitride.

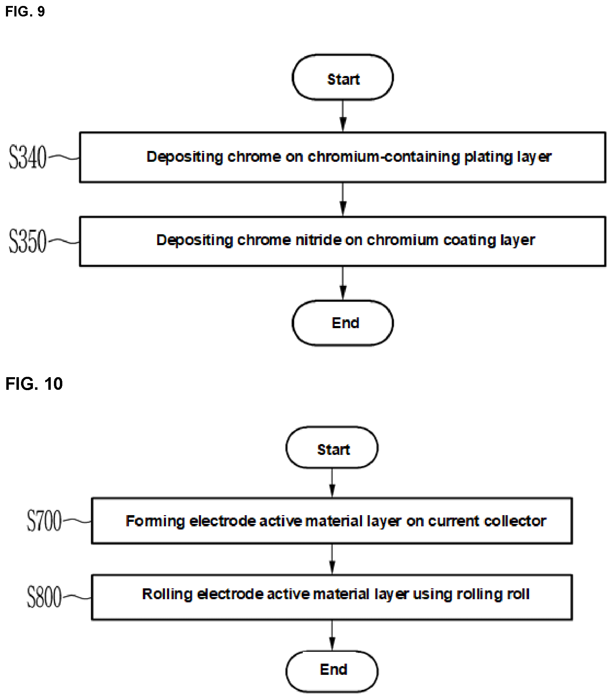

Referring to FIGS. 3 and 9, the method for manufacturing a rolling roll according to the present embodiment may further comprise steps (S340, S350) of coating chromium or chromium nitride on the chromium-containing plating layer between the step (S200) of forming the chromium-containing plating layer and the step (S300) of coating the metal nitride layer. More specifically, as shown in FIG. 9, after the step (S200) of forming the chromium-containing plating layer, a step (S340) of depositing chromium on the chromium-containing plating layer 1200, and a step (S350) of depositing chromium nitride on the chromium coating layer may be further performed.

Thereby, the method for manufacturing a rolling roll according to the present embodiment has advantages that in the step (S200) of forming the chromium-containing plating layer, the chromium-containing plating layer is formed through crack refinement or crack-free plating, thereby preventing penetration of a plating solution through cracks, fundamentally blocking leakage of foreign matter from hair cracks during the heat treatment process, and improving the yield of the plasma coating process. Furthermore, through crack refinement or crack-free plating, the chromium-containing plating layer can increase its hardness to 1,000 to 1,300 Hv, and thus prevent occurrence of rapid wear even after the outermost Ti nitride coating is peeled off.

In addition, the method for manufacturing a rolling roll according to the present embodiment reduces the coefficient of friction to a level of 0.4-0.7 through deposition of Ti-based nitride in the metal nitride layer coating step (S300), gradually increases the hardness up to a maximum of 3,500 Hv, reduce wear of the roll, fundamentally prevent peeling of the coating layer due to blister defects caused by hydrogen generation, and significantly extend the service life of the rolling roll 1000. That is, the method for manufacturing the rolling roll according to the present embodiment can extend the replacement cycle of the rolling roll 1000, thereby reducing production costs and improving the stable rolling productivity of electrode active materials.

FIG. 10 is a flowchart showing a method for manufacturing an electrode according to another embodiment of the present disclosure.

Referring to FIG. 10, a method for manufacturing a secondary battery according to another embodiment of the present disclosure includes a step (S700) of forming an electrode active material layer on a current collector; and a step (S800) of rolling the electrode active material layer by a rolling roll 1000.

Thereby, the method for manufacturing a secondary battery according to the present embodiment has the advantages that a secondary battery can be manufactured by rolling the electrode active material layer by the rolling roll 1000 having a relatively long life, thereby improving the productivity while reducing the production cost of the secondary battery.

Hereinafter, the present disclosure will be described with reference to more specific examples. However, these examples are intended for purposes of illustration only and are not intended to limit the scope of the present disclosure.

### <Example 1>

First, a high-strength steel base material made of SKD11 material having sizes of 40 mmL x 20 mmW x 10 mmH was used. The surface of this roll base material was sandblasted using aluminum oxide (Al₂O₃) with an average particle size of about 90 µm as the abrasive, and the average surface roughness (Ra) was set to about 3 µm. Next, pure water at 20 to 25°C (room temperature) was sprayed three times repeatedly over the entire surface of the sandblasted roll base material and subjected to surface cleaning for 15 minutes.

Meanwhile, an aqueous solution containing 200 g/L of chromic anhydride, 25 g/L of sulfuric acid, and 10 g/L of ethyl sulfonate catalyst was prepared, and used as the plating solution.
The temperature of the plating solution was maintained at 50 °C.

The roll base material was immersed in the plating solution and electroplated at 50°C to form a chromium-containing plating layer with a thickness of 100-200 µm on the surface of the roll base material.

### <Example 2>

In the same manner as in Example 1, a chromium-containing plating layer was formed on the roll base material, and heat-treated at a temperature of 130°C or more to 250°C or less for the period of 8 hours more to 40 hours or less to remove residual hydrogen.

### <Example 3>

In the same manner as in Example 1, a chromium-containing plating layer was formed on a roll base material, and then a chromium nitride (CrN) coating layer with a thickness of 0.3-0.5 µm, a titanium nitride (TiN) coating layer with a thickness of 0.5-1.0 µm, a titanium-aluminum composite nitride (TiAlN) coating layer with a thickness of 0.5-1.0 µm, and a titanium carbonitride (TiCN) coating layer with a thickness of 0.5-1.0 µm were sequentially deposited using a plasma vacuum (sputtering) method.

In this case, sputtering was performed under conditions where there was a heater generating heat at a temperature of 80°C or more to 200°C or less in a vacuum state.

### <Comparative Example 1>

First, a high-strength steel base material made of SKD11 material having sizes of 40 mmL x 20 mmW x 10 mmH was used.

Meanwhile, an aqueous solution containing 200 g/L of chromic anhydride and 25 g/L of sulfuric acid was prepared, and used as the plating solution. At this time, the temperature of the plating solution was maintained at 50°C.

The roll base material was immersed in the plating solution and electroplated at 50°C to form a chromium-containing plating layer with a thickness of 100-200 µm on the surface of the roll base material.

### <Comparative Example 2>

In the same manner as in Comparative Example 1, a chromium-containing plating layer was formed on the roll base material, and heat-treated at a temperature of 130°C or more to 250°C or less for the period of 8 hours more to 40 hours or less to remove residual hydrogen.

### <Comparative Example 3>

In the same manner as in Comparative Example 1, a buffer layer (CrN) with a thickness of 0.1-1.0 µm was deposited on the chromium-containing plating layer of Comparative Example 1, followed by a DLC coating in a thickness of 1.5-2.5 µm. The DLC coating can be performed by a hydrocarbon-based (CₙHₙ) plasma gas.

### <Experimental Example 1 - SEM image capture and crack size confirmation>

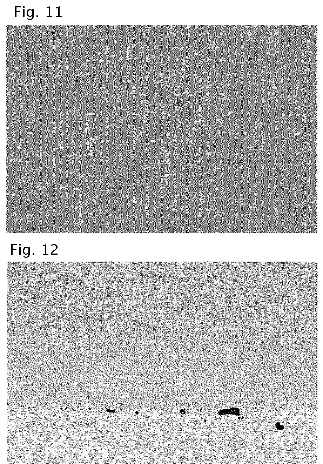

SEM images of the chromium-containing plating layers of Example 1 and Comparative Example 1 were captured using an electron microscope. FIG. 11 shows an SEM image of Example 1, and FIG. 12 shows an SEM image of Comparative Example 1.

Specifically, the cross sections of the samples manufactured in Example 1 and Comparative Example 1 were observed under a SEM image at 1500x magnification (unit: µm), and the average of the 10 maximum values observed was calculated as a representative value.

Referring to FIGS. 11 and 12, it can be confirmed that in Example 1, most cracks were 5 µm or less in length, whereas in Comparative Example 1, cracks having lengths of 10 µm or more were observed.

Thereby, unlike Comparative Example 1, it can be confirmed that as an alkyl sulfonate catalyst was used in combination with the plating solution as in Example 1, the crack length was effectively reduced. That is, Example 1 could effectively prevent defects caused by cracks compared to Comparative Example 1.

### <Experimental Example 2_ Measurement of hydrogen content, residual hydrogen mass ratio, and hardness of chromium-containing plating layer>

The residual hydrogen density and hardness of the chromium-containing plating layers were measured for Examples 1 and 2, and Comparative Examples 1 and 2, respectively, and the results are shown in Table 1 below.

The amount of hydrogen was measured using a thermal desorption-gas chromatography mass spectrometry (TD-GC/MS). The samples of Example 1, Example 2, Comparative Example 1, and Comparative Example 2 were heated to 80°C, and the amount of hydrogen gas desorbed from the sample surface was measured. The residual hydrogen mass ratio is a value obtained by dividing the previously measured amount of hydrogen by the weight of the sample.

Hardness was measured using a Vickers hardness tester under a load of 300 kgf, and the average of five measurements was taken.

**[Table 1]**

| | Example 1 | Example 2 | Comparative Example 1 | Comparative Example 2 |
|---|---|---|---|---|
| Weight of sample (g) | 58.1 | 57.7 | 58.9 | 58.8 |
| Amount of hydrogen (µg) | 714.6 | 188.7 | 541.9 | 87.6 |
| Residual hydrogen mass ratio (amount of hydrogen/weight of sample , wppm) | 12.3 | 3.27 | 9.2 | 1.49 |
| Hardness (Hv) | 906 | 932 | 880 | 895 |

Referring to the results of the hydrogen amount and residual hydrogen mass ratio in Table 1, it can be confirmed that, comparing Example 1 with Comparative Example 1, Example 1 desorbed a relatively larger amount of hydrogen from the surface of the chromium-containing plating layer than in Comparative Example 1. Furthermore, when comparing Example 2 with Comparative Example 2, it can be confirmed that Example 2 desorbed a relatively larger amount of hydrogen from the surface of the chromium-containing plating layer than in Comparative Example 2.

In this manner, it can be confirmed that in the chromium-containing plated layers prepared as in Examples 1 and 2, the amount of hydrogen desorbed or removed from the surface of the chromium-containing plating layer is relatively large compared to the chromium-containing plating layers prepared as in Comparative Examples 1 and 2.

Comparing Example 2 with Example 1, it can be confirmed that Example 2 desorbed a relatively small amount of hydrogen from the surface of the chromium-containing plating layer compared to Example 1. Furthermore, comparing Comparative Example 2 with Comparative Example 1, it can be confirmed that Comparative Example 2 desorbed a relatively small amount of hydrogen from the surface of the chromium-containing plating layer compared to Comparative Example 1.

In this manner, it was confirmed that through the heat treatment process as in Example 2 and Comparative Example 2, a portion of the hydrogen already contained in the chromium-containing plating layer was removed, and the amount of hydrogen desorbed or removed from the surface of the chromium-containing plating layer was reduced compared to Example 1 and Comparative Example 1.

Referring to the hardness results in Table 1, it can be confirmed that comparing Example 1 with Comparative Example 1, the hardness of the chromium-containing layer in Example 1 is relatively greater than that in Comparative Example 1. Furthermore, comparing Example 2 with Comparative Example 2, it can be confirmed that the hardness of the chromium-containing layer in Example 2 is relatively greater than that of Comparative Example 2.

In this manner, it can be confirmed that the chromium-containing plating layers prepared in Examples 1 and 2 have greater hardness than the chromium-containing plating layers prepared in Comparative Examples 1 and 2. Looking at the experimental results of Experimental Example 1, it can be confirmed that Example 1 minimizes plating defects by forming cracks with smaller lengths than Comparative Example 1, and as a result, the hardness of the chromium-containing plating layer in Example 1 is greater than that of Comparative Example 1. This can be similarly explained for Example 2 as well.

Comparing Example 2 with Example 1, it can be confirmed that the hardness of the chromium-containing plating layer in Example 2 is relatively higher than that of Example 1. Furthermore, comparing Comparative Example 2 with Comparative Example 1, it can be confirmed that the hardness of the chromium-containing plating layer in Comparative Example 2 is relatively higher than that in Comparative Example 1.

In this manner, it can be confirmed that through the heat treatment process as in Example 2 and Comparative Example 2, the hydrogen already contained in the chromium-containing plating layer is partially removed, thereby minimizing coating defects. Thereby, it can be confirmed that the hardness of the chromium-containing plating layers in Example 2 and Comparative Example 2 is high compared to that in Example 1 and Comparative Example 1, respectively.

### <Experimental Example 3_ Measurement of residual hydrogen density, hardness, coefficient of friction, and adhesion of coating layer>

The residual hydrogen density, hardness, coefficient of friction, and adhesion of the coating layers in Example 3 and Comparative Example 3 were measured, and the results are shown in Table 2 below.

The residual hydrogen density was measured using a thermal desorption-gas chromatography mass spectrometry (TD-GC/MS), and may be a value obtained by dividing the amount of hydrogen gas desorbed from the surface of the samples of Example 3 and Comparative Example 3 through heat treatment to 80°C by the volume of the sample.

Hardness was measured as the average of five measurements under a load of 300 kgf using a Vickers hardness tester.

The coefficient of friction was measured using a tribometer under a load of 5 N and a speed of 200 rpm.

Adhesion was measured by a scratch test, and the force at which peeling occurred was measured while increasing the pressing force. In the case of Comparative Example 3, measurement was performed under loads of 0.5-30 N and a speed of 0.55 mm/sec. In the case of Example 3, measurements were performed under conditions of a load of 1 to 60 N and a speed of 0.55 mm/sec.

**[Table 2]**

| | Comparative Example 3 | Example 3 | | | |
|---|---|---|---|---|---|
| | DLC coating layer | CrN coating layer | TiN coating layer | TiAlN coating layer | TiCN coating layer |
| Residual hydrogen density (ppm/cm³ ) | 690 | 0 | 0 | 0 | 0 |
| Hardness (Hv) | 2,000 | 1,500∼1,900 | 2,000∼2,500 | 2,500∼3,000 | 3,000∼3,500 |
| Coefficient of friction | 0.05 | 0.4 | 0.7 | 0.6 | 0.4 |
| Adhesion (N) | 17.8 | 30 | 30 | 30 | 30 |

Referring to Table 2, it can be confirmed that the residual hydrogen density in the DLC coating layer of Comparative Example 3 is 690 ppm/cm³, whereas the residual hydrogen density of Example 3 was 0 in all of the respective coating layers. In particular, when the hydrogen density is 500 ppm/cm³ or more, blister defects due to residual hydrogen occur. Therefore, while these blister defects occur in Comparative Example 3, the blister defects can be effectively prevented in Example 3.

Furthermore, it can be confirmed that the hardness of the DLC coating layer of Comparative Example 3 was 2,000 Hv, whereas the hardness of the coating layer of Example 2 gradually increased in the order of chromium nitride (CrN), titanium nitride (TiN), titanium-aluminum composite nitride (TiAIN), and titanium carbonitride (TiCN) coatings.

Furthermore, it can be confirmed that the coefficient of friction of Comparative Example 3 is 0.05, whereas the coating layer of Example 3 has a coefficient of friction of 0.4-0.7. Generally, when the coefficient of friction is 0.1 or less, an electrode slip phenomenon occurs between rolls during rolling. However, while this slip phenomenon occurs in Comparative Example 3, it is effectively prevented in Example 2.

Furthermore, it can be confirmed that the adhesion of Comparative Example 3 was 17.8 N, whereas that of Example 3 was 30 N. In other words, in the case of Example 3, peeling of each coating layer hardly occurs due to high adhesion, whereas in the case of Comparative Example 3, peeling of the coating layer easily occurs due to lower adhesion compared to Example 3.

Although preferred embodiments of the present disclosure have been shown and described above, the scope of the present disclosure is not limited thereto, and numerous other variations and modifications can be made by those skilled in the art using the basic principles of the invention defined in the appended claims, which also falls within the spirit and scope of the invention.

### [DESCRIPTION OF REFERENCE NUMERALS]

1000: rolling roll
1100: roll base material
1200: chrome-containing plating layer
1300: coating layer

## Claims

1. A rolling roll comprising:
a roll base material; and
a chromium-containing plating layer formed on the roll base material, with the maximum length of the cracks formed on the surface being 5 µm or less.

2. The rolling roll according to claim 1,
wherein the roll base material has a surface irregularity portion with a maximum height of 5 µm or more to 25 µm or less.

3. The rolling roll according to claim 1,
wherein the roll base material comprises chromium steel.

4. The rolling roll according to claim 1,
wherein a thickness of the chromium-containing plating layer is 100 µm or more to 150 µm or less, and
a hardness of the chromium-containing plating layer is 1000Hv or more to 1300Hv or less.

5. The rolling roll according to claim 1,
wherein a residual hydrogen density of the chromium-containing plating layer is 0.1 ppm/cm³ or more to 0.25 ppm/cm³ or less.

6. The rolling roll according to claim 1,
further comprising a coating layer formed on the chromium-containing plating layer,
wherein the coating layer comprises a metal nitride.

7. The rolling roll according to claim 6,
wherein the coating layer comprises a chromium nitride layer formed on the chromium-containing plating layer, and a titanium nitride layer formed on the chromium nitride layer.

8. The rolling roll according to claim 6,
wherein the coating layer further comprises a chromium coating layer located between the chromium-containing plating layer and the chromium nitride layer.

9. A rolling roll comprising:
a roll base material;
a chromium-containing plating layer formed on the roll base material, and
a first coating layer formed on the chromium-containing plating layer and comprising titanium nitride.

10. The rolling roll according to claim 9,
further comprising one or more second coating layers formed between the chromium-containing plating layer and the first coating layer, and comprising chromium or its nitride.

11. The rolling roll according to claim 10,
wherein a thickness of the second coating layer is 0.2 µm or more to 1 µm or less, and
a hardness of the second coating layer is 1000Hv or more to 2000Hv or less.

12. The rolling roll according to claim 9 to 10,
wherein the first coating layer comprises:
a first sub-coating layer formed on the chromium-containing plating layer or the second coating layer, and comprising titanium nitride (TiN);
a second sub-coating layer formed on the first sub-coating layer, and comprising a titanium-aluminum composite nitride; and
a third sub-coating layer formed on the second sub-coating layer, and comprising titanium carbonitride (TiCN).

13. The rolling roll according to claim 12,
wherein the first to third sub-coating layers each have a thickness of 0.3 µm or more to 1.5 µm or less, and
the hardness increases as it goes from the first sub-coating layer to the third sub-coating layer.

14. The rolling roll according to claim 13,
wherein the first sub-coating layer has a hardness of 2000 Hv or more,
the second sub-coating layer has a hardness of 2500 Hv or more, and
the third sub-coating layer has a hardness of 3000 Hv or more.

15. The rolling roll according to claim 12,
wherein the rolling roll has a coefficient of friction that decreases from the first sub-coating layer to the third sub-coating layer.

16. The rolling roll according to claim 15,
wherein the first sub-coating layer has a coefficient of friction of 0.65 to 0.75,
the second sub-coating layer has a coefficient of friction of 0.55 to 0.65, and
the third sub-coating layer has a coefficient of friction of 0.35 to 0.45.

17. The rolling roll according to claim 12,
wherein the first to third sub-coating layers have a residual hydrogen density of 100 ppm/cm³ or less.

18. A method for manufacturing a rolling roll, the method comprising the steps of:
forming a surface irregularity portion on the surface of a roll base material;
forming a chromium-containing plating layer on the roll base material using a plating solution containing a chromium-containing raw material and sulfuric acid; and
coating a metal nitride layer on the chromium-containing plating layer,
wherein in the forming the chromium-containing plating layer, the plating solution further comprises a sulfonic acid-based organic catalyst, or plating is performed in a state where the plating solution is heated to a temperature of 65°C or more to 90°C or less.

19. The method for manufacturing a rolling roll according to claim 18,
wherein the forming a surface irregularity portion comprises sandblasting or shotblasting the surface of the roll base material.

20. The method for manufacturing a rolling roll according to claim 18,
further comprising removing residual hydrogen by heat treatment at a temperature of 130°C or more to 250°C or less for 8 hours or more and 40 hours or less to remove residual hydrogen, after forming the chromium-containing plating layer.

21. The method for manufacturing a rolling roll according to claim 18,
further comprising performing at least one of polishing and cleaning the chromium-containing plating layer between the forming the chromium-containing plating layer and the coating the metal nitride layer.

22. The method for manufacturing a rolling roll according to claim 18,
wherein the chromium-containing raw material comprises chromic anhydride, and
the sulfonic acid-based organic catalyst comprises an alkyl sulfonate having 1 to 5 carbon atoms.

23. The method for manufacturing a rolling roll according to claim 18,
wherein the coating a metal nitride layer comprises performing plasma vacuum deposition (sputtering) of the metal nitride.

24. The method for manufacturing a rolling roll according to claim 18,
wherein the coating a metal nitride layer comprises:
depositing titanium nitride (TiN) on the chromium-containing plating layer;
depositing a titanium-aluminum composite nitride on the titanium nitride; and
depositing titanium carbonitride (TiCN) on the titanium-aluminum composite nitride.

25. The method for manufacturing a rolling roll according to claim 24,
further comprising coating chromium or chromium nitride on the chromium-containing plating layer between the forming the chromium-containing plating layer and the coating the metal nitride layer.

26. A method for manufacturing an electrode, the method comprising the steps of:
forming an electrode active material layer on a current collector; and
rolling the electrode active material layer using the rolling roll of claim 1 or 9.
